# EUROPEAN PATENT SPECIFICATION

(11) **EP 4 455 938 B1**
(45) Date of publication and mention of the grant of the patent: **25.11.2026**
(21) Application number: 23315104.2
(22) Date of filing: 25.04.2023
(51) Int. Cl.: G06N 20/00, G06N 3/044, G06N 3/065, G01R 33/12

(54) **IMPROVED CLASSIFICATION DEVICE OF THE "IN MATERIO COMPUTING" TYPE**
VERBESSERTE KLASSIFIKATIONSVORRICHTUNG VOM IN MATERIO COMPUTING-TYP
DISPOSITIF DE CLASSIFICATION AMÉLIORÉ DU TYPE MATERIO COMPUTING

(43) Date of publication of application: 30.10.2024
(73) Proprietor: Centre National de la Recherche Scientifique, 75016 Paris (FR); Université Grenoble Alpes, 38400 Saint-Martin-d'Hères (FR); Commissariat à l'Energie Atomique et aux Energies Alternatives, 75015 Paris (FR); Institut Polytechnique de Grenoble, 38000 Grenoble (FR); Pinna, Daniele, 1180 Uccle (BE)
(72) Inventor: Gaudin, Gilles, 38700 CORENC (FR); Miron, Ioan Mihai, 38000 GRENOBLE (FR); Yang, Haozhe, 20014 SAN SEBASTIAN (ES); Vatajelu, Ioana, 38950 SAINT MARTIN LE VINOUX (FR); Pinna, Daniele, 1180 Uccle (BE)
(74) Representative: IPAZ

(56) References cited:
- EP-A1- 4 160 484
- NA LEI ET AL: "Strain-controlled magnetic domain wall propagation in hybrid piezoelectric/ferromagnetic structures", NATURE COMMUNICATIONS, vol. 4, 22 January 2013 (2013-01-22), UK, pages 1378, XP055300354, ISSN: 2041-1723, DOI: 10.1038/ncomms2386

## Description

The present invention relates to a classification device of the "in materio computing" type.

The term "in materio computing" refers to an approach based on the use of a material system to replicate the operation of an artificial neural network.

An "in materio computing" device comprises a material system which is, preferably positioned between an input layer and an output layer.

The input layer pre-processes the signal of interest (i.e. the signal carrying the information to be processed), in order to obtain a plurality of input data.

This plurality of input data is applied to the material system, where it is treated according to a spatio-temporal process.

The state of the material system at the end of this spatio-temporal process is analysed by the output layer, in order to identify the class with which to label the signal of interest.

The material system must have a high dimensionality to exhibit a separating power between signals of interest that is suitable for the classification task performed by the classification device. It must also have other characteristics such as a short-term memory and a local non-linear response to the input data.

The inventors have already filed a patent application (EP 21306379.5) disclosing a classification device comprising a pre-processing stage, an identification stage, and a material system interposed between the pre-processing stage and the identification stage, wherein : the material system comprises an inhomogeneous magnetic medium subdivided into a plurality of zones, each zone being in magnetic communication, directly or indirectly via one or more intermediate zones, with at least one so-called source zone, each zone being either in a first magnetic state (in which a magnetization of said zone is oriented in a first direction) or in a second magnetic state (in which the magnetization of said zone is oriented in a second direction opposite to the first direction); the material system comprises an initialization module for placing the plurality of zones of the magnetic medium in a predefined initial magnetic configuration, wherein the plurality of zones is in the first magnetic state with the exception of the source zone, which is placed, at least partially, in the second magnetic state; the pre-processing stage is adapted to transform a signal of interest into an excitation signal; the material system comprises an excitation module adapted to generate, from the excitation signal, a physical excitation quantity adapted to excite the magnetic medium so as to displace magnetic domain walls, which are located at the interface between a domain of the magnetic medium placed in the first magnetic state and a domain of the magnetic medium placed in the second magnetic state, the excitation module applying the physical excitation quantity during a predefined time interval, so as to increase the number of zones in the second magnetic state from the source zone; the material system comprises a readout module adapted to measure, after the application of the physical excitation quantity, the final magnetic configuration reached by the magnetic medium, the reading signal of the final magnetic configuration being applied as an input to the identification stage; and the identification stage is adapted to determine, based on the final magnetic configuration, a class to which the signal of interest belongs among a plurality of predetermined classes. Domain wall propagation control is specified in NA LEI ET AL: "Strain-controlled magnetic domain wall propagation in hybrid piezoelectric/ferromagnetic structures", NATURE COMMUNICATIONS, vol. 4, 22 January 2013 (2013-01-22), ISSN: 2041-1723.

While this classification device operates properly, it is limited in that once manufactured, the magnetic medium is fixed and dedicated to only one family of signals, typically with a similar frequency response.

The aim of the present invention is to propose an improvement to this known classification device.

To this end, the invention relates to a device according to the appended claims.

The invention and its advantages will be better understood on reading the following detailed description of two embodiments, given only as a non-limiting example, this description being made with reference to the appended drawings in which:
- Figure 1 is a general functional representation of a classification device according to the invention;
- Figure 2 is a schematic representation of a first embodiment of a classification device according to the invention;
- Figure 3 is a schematic representation of a magnetic control element for controlling the state of the gates of the classification device of Figure 2;
- Figure 4 is a bloc representation of a method of use of the classification device; and,
- Figure 5 is a schematic representation of an electric control element for controlling the state of a gate in a second embodiment of a classification device according to the invention;

In the inhomogeneous magnetic system, two zones are in magnetic communication through a gate.

In the classification device, the information processing is thus based on the fact that the propagation of a magnetic domain wall is determined by the plurality and diversity of the gates it sees on its propagation path.

According to the invention, the state of all or part of the gates is controlled dynamically to adjust the ease or the difficulty with which the magnetic domain wall will pass through the gates.

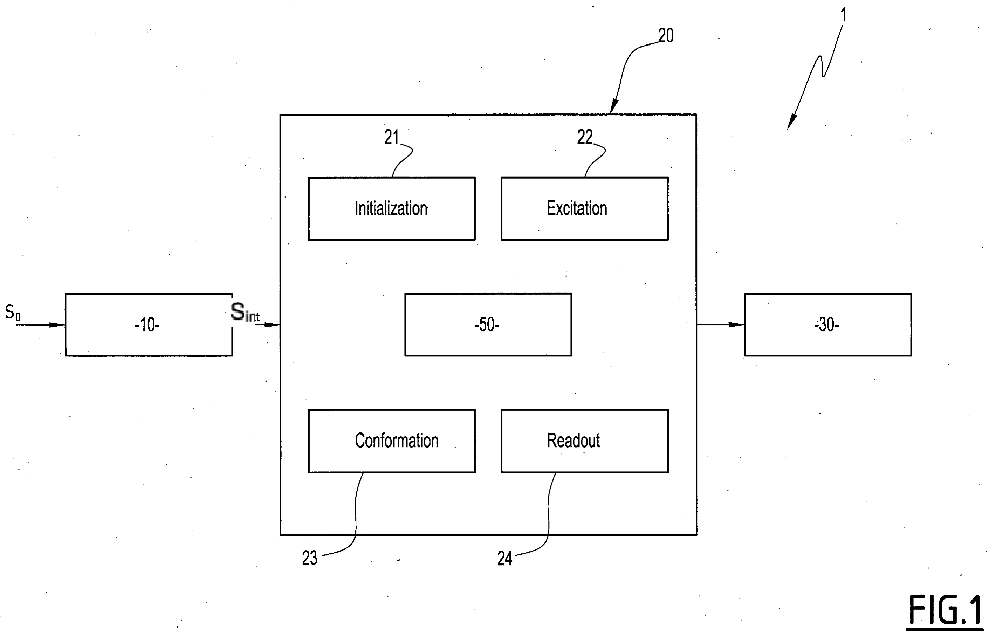

Figure 1 is a functional representation of the classification device according to the invention.

This classification device 1 comprises:
- a pre-processing input stage 10;
- a material system 20; and
- an identification output stage 30.

The pre-processing stage 10 applies suitable treatments to the signal of interest (i.e. the signal carrying the information to be processed), S₀, in order to obtain a pre-process signal, Sᵢₙ, which is applied to the material system 20.

The material system 20 comprises:
- an inhomogeneous magnetic medium 50, subdivided into a plurality of zones or chambers, each chamber being in magnetic communication with at least one other chamber through a gate. Each chamber is either in a first magnetic state, in which a magnetisation of said chamber is oriented along a predefined reference direction, or in a second magnetic state, in which the magnetisation of said chamber is parallel to a direction opposite to the predefined reference direction.
- means of initialisation 21, to put the chambers of the medium 50 in an initial magnetic configuration;
- means of excitation 22, to apply an excitation signal Sₑₓₜ, on the medium to move the magnetic domain walls between the magnetic domains of opposite magnetisations through the medium 50, to reach a final magnetic configuration from the initial magnetic configuration;
- means of readout 24, to read the final magnetic configuration of the medium and generate an output signal, Sₒᵤₜ; and,
- means of conformation 23, to set the state of each coupling gate of the medium 50.

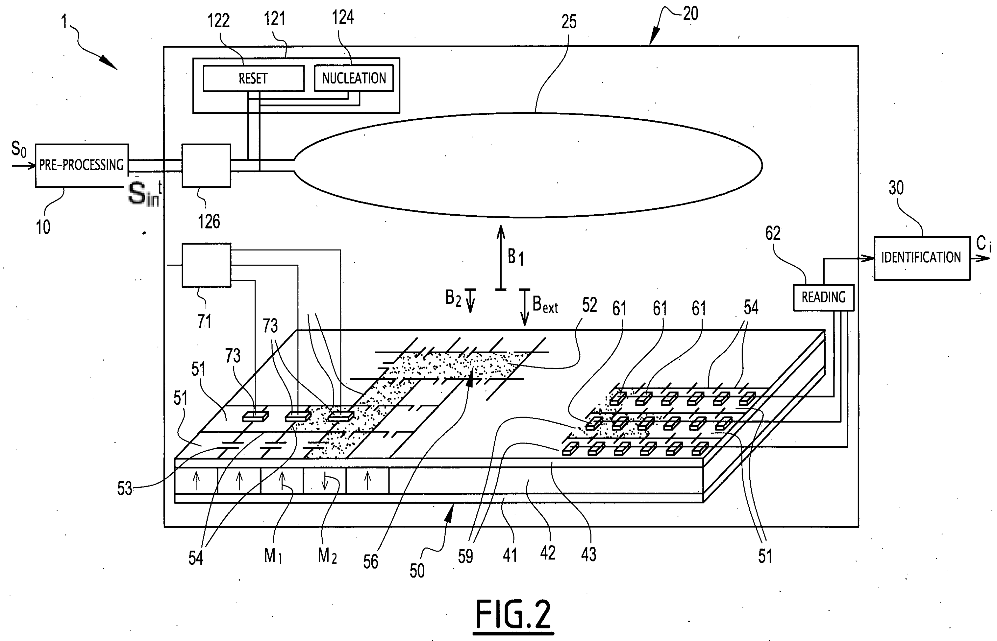

Referring to Figure 2, the inhomogeneous magnetic medium 50 is, in this first embodiment, a two-dimensional medium, for example of rectangular shape. Its thickness is much smaller than its characteristic length and width. Alternatively, other geometries than rectangular are possible.

The medium 50 is for example made up of the stacking of a plurality of layers, at least one layer of which is made of a magnetic material whose magnetisation can be modified. For example, the inhomogeneous magnetic medium 50 comprises three layers 41, 42 and 43, for example of Pt, Co and Pt respectively.

For example, the magnetisation of the intermediate layer 42 is oriented along a reference direction perpendicular to the plane of the medium 50.

In this first embodiment, the inhomogeneous magnetic medium 50 is provided with a plurality of chambers 51. It is these chambers that make the magnetic medium inhomogeneous.

A chamber 51 is bounded by walls 54 and has at least one gate 53 for communication with an adjacent chamber.

The gate is arranged through one of the walls of the chamber. The gate allows movement of the magnetic domain wall between the two chambers connected by that gate. As it will be explained below, the state of a gate 53 may be individually controlled. For example, in a simple embodiment, one gate 53 may be either closed (or nearly closed, i.e. the coupling between the two chambers is low in order to prevent or limit the movement of the magnetic domain wall) or open (or nearly open, i.e. the coupling between the two chambers is high to favour the movement of the magnetic domain wall). In more interesting embodiments, the state of one gate is modulated between several possible states, or even along a continuum of states.

The chambers may have different geometries. In Figure 2, the chambers 51 are rectangular, but have varying lengths and/or widths. Alternatively, other geometries are possible, such as chambers with n sides (n greater than or equal to 3 and typically less than 10).

In Figure 2, the gates 53 between two neighbouring chambers take the form of corridors, arranged parallel to two sides of the interconnected chambers 51. The gates may have various lengths, widths and positions on walls.

Alternatively, one chamber may have more than one gate.

Any chamber 51 is accessible from a chamber of the medium 50, called the source chamber 52, by one or more paths through a variable number of intermediate chambers (this number may be zero).

As they move under the effect of the excitation quantity, the magnetic domain walls propagate along one or more of these paths.

A final magnetic configuration is obtained after the application of the excitation quantity.

The chambers 51 are manufactured by locally modifying the magnetic material of the medium 50, so as to make it non-magnetic or by making it discontinuous, in order to delimit the walls 54 and the gates 53. This can be done, for example, by etching the magnetic material through a mask made of a resin or a sacrificial material (metals, dielectric, etc.), the design of the chambers having been previously defined in said mask by means of an optical or electronic lithography step, for example. Alternatively, the chambers 51 are made by means of a focused laser whose intensity is strong enough to make the magnetic material locally non-magnetic.

Each chamber 51 thus delimits a zone whose magnetisation can be oriented either in one direction along the reference direction, M1, the chamber then being in a first magnetic state, or in an opposite direction, M2, the chamber then being in a second magnetic state. In the present embodiment, the reference direction is perpendicular to the plane of the medium 50. This is illustrated in the figures by a white box when the chamber is in the first state and a dotted box when the chamber is in the second state.

In the present embodiment, the chambers are adjacent to each other, so that the inhomogeneous magnetic medium is compact.

Besides the inhomogeneous magnetic medium 50, the material system 20 comprises a coil 25, as a means of generating a magnetic field. The coil 25 is arranged in the immediate vicinity of the medium 50 (for example above or below medium 50) in such a way that it can generate a substantially uniform magnetic field over the entire extent of the medium 50 this magnetic field being oriented along the reference direction.

The means of initialisation 21 of the material system 20 comprises the coil 25 and an initialisation module 121, which, by supplying a suitable current to the coil 25, makes it possible to set the inhomogeneous magnetic medium 50 in a predefined initial magnetic configuration, so that any classification task starts from the same and known magnetic configuration of the medium 50.

This initial magnetic configuration is for example defined as the configuration in which all the chambers 51 are in the first magnetic state M₁ except for the source chamber 52, which is placed, at least partially, in the second magnetic state M₂.

In the first embodiment, the initialization module 121 comprises, for example, a reset bloc 122 and a nucleation bloc 124, which are connected to the coil 25 so that it can be supplied with suitable currents.

When powered by the reset bloc 122, the coil 25 generates a first magnetic field B₁ parallel to the reference direction and sufficiently intense over the entire surface of the magnetic material to align the magnetisation of each chamber 51 parallel to the reference direction, i.e. to set all the chambers in the first magnetic state M1. The reset bloc 122 thus puts the medium 50 in a uniform magnetic configuration.

To be able to set the medium 50 in the initial magnetic configuration, a local defect is induced in the magnetic material of the source chamber 52 to ensure the nucleation of a magnetic domain at this precise location when a second magnetic field B₂ is applied.

The coil 25 is then energised by the nucleation bloc 124 so as to generate this second magnetic field B₂. This field is anti-parallel to the reference direction and is locally sufficiently strong to switch the magnetisation of only a defined portion of the source chamber 52 into the second magnetic state M₂.

Alternatively, the reset bloc or the nucleation bloc is associated with a dedicated magnetic field generating device. For example, the nucleation module drives an electromagnet arranged in the vicinity (for example directly above or below) the source chamber 52 in order to generate the second magnetic field suitable for nucleation. The presence of a defect in the source chamber material may then no longer be necessary.

Alternatively, all means known to the skilled person and capable of modifying the configuration of the medium 50 to set it to a predefined initial magnetic configuration and, if necessary, nucleate a domain in the source chamber, can be used. For example, instead of using a magnetic field, an electric field or an electric current could be used.

Alternatively, the initial magnetic configuration is such that the medium presents several source zones. If a nucleation module is implemented, then this nucleation module allows the different source zones to be placed, at least partially, in the second magnetic state. The nucleation module then comprises, for example, as many electromagnets arranged in the immediate vicinity of each of the source zones to generate a second magnetic field adapted to modify the magnetisation of a portion of each of the source zones, antiparallel to the reference direction. Alternatively, a local defect is induced in the magnetic material of each source zone to ensure that a magnetic domain is nucleated in each source zone upon the application of the second magnetic field, for example generated by means of an extended coil such as coil 25.

The excitation means 22 of the material system 20 comprises the coil 25 and an excitation module 126 connected to the coil 25. The excitation module 126 supplies the coil 25, during a predefined time interval, with a current suitable to generate an excitation magnetic field, Bₑₓₜ. In this first embodiment, the current produced by the module 126 is derived from the input signal Sᵢₙ delivered by the pre-processing input stage 10.

The excitation magnetic field Bₑₓₜ is capable of moving the magnetic domain walls, i.e. the interface between a domain in the first magnetic state and a domain in the second magnetic state.

Alternatively, the excitation module is associated with a dedicated device for generating the physical excitation quantity, independent of the other components of the material system.

Alternatively, the excitation module is such that the physical excitation quantity is an electric field or an electric current rather than a magnetic field.

The readout means 24 of the material system 20 includes an array of magnetic sensors 61 and a readout module 62 for determining the final magnetic configuration in which the inhomogeneous magnetic medium 50 has been set after having been subjected to the physical excitation quantity. Each magnetic sensor 61 is located in close proximity to a corresponding chamber 51. It measures whether this chamber is in the first magnetic state M₁ or in the second magnetic state M₂. The readout module 62 collects the signals from each magnetic sensor 61 and generates the readout signal Sₒᵤₜ to transfer the information to the identification stage 30.

The identification stage 30 preferably consists of an artificial neural network. The latter is configured to determine the class to which the signal of interest belongs among a plurality of predefined classes. This determination is based on the final magnetic configuration that this signal of interest has conferred to the inhomogeneous magnetic medium. This artificial neural network can be simple, like a "perceptron", so as not to have to carry out complex calculations, particularly in the learning phase. Alternatively, this artificial neural network comprises several layers.

The means of conformation 23 of the material system 20 comprises, associated with each gate 53, a control element 73 for the modulation of the coupling properties of that gate, and a conformation module 71 to address each control element 73. In figure 2, only three control elements 73 are represented for sake of clarity. Alternatively, only a subset of gates of the medium is associated with a control element.

The control element 73 is positioned on the magnetic medium 50, directly above the gate 53 which it controls. The control element 73 aims at controlling, in a reversible way, the local value of some physical parameters that impact the magnetic coupling value of the gate so as to influence the propagation of the magnetic domain wall through this gate between the two connected chambers. This coupling value defines the state of the gate.

In the first embodiment, the control element is a magnetic control element.

The function of the magnetic control element is to generate a local magnetic field such as to create either a potential barrier which favours the movement of the magnetic domain wall through the gate (open state), or on the contrary a potential which limits the movement through the gate (closed state).

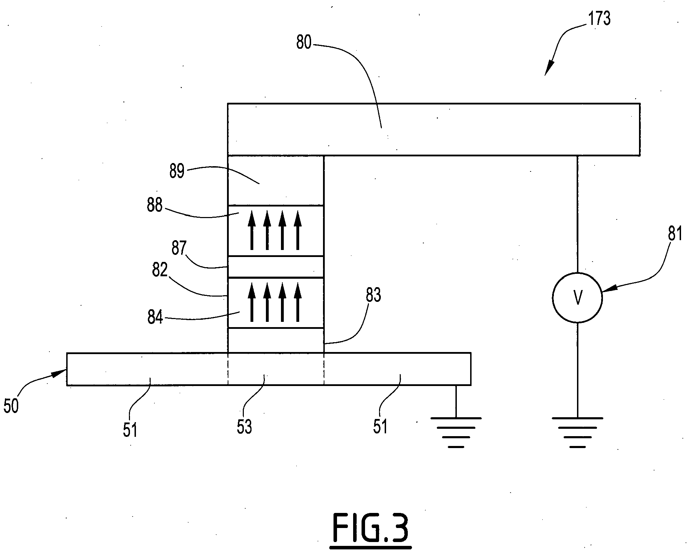

The magnetic control element is for example structured as shown in Figure 3.

The magnetic control element 173 has a magnetic layer 84, presenting a magnetisation, for example perpendicular to the plane of the medium 50. The direction of the magnetisation can be modified, for example, upwards to place the gate in the closed state and downwards to place the gate in the open state.

The magnetic layer 84 is for example a multilayer of Co and Pt, or Co and Pd, or Co, or Ni,... or an alloy of the type CoNi, CoPt,... or any other material with perpendicular magnetisation.

Alternatively, a magnetic layer with planar magnetisation would be made of a material such as NiFe, Co, CoFe, CoFeB or any other material with planar magnetisation.

This magnetisation, once established, is fixed, i.e. it must not be modified by the propagation of the magnetic domain walls in the medium, nor by the excitation quantity used to propagate the magnetic domain walls, and preferably also by the initialisation field used to place the material system in an initial magnetic configuration.

The magnetic layer 84 is preferably placed on the medium 50 via a contact layer 83. The contact layer consists of a non-magnetic material, which can be a dielectric such as MgO, AlOx,..., or a conducting material such as Cu, Ru, Ir, Pt,...

The change in the direction of the magnetization of the magnetic layer is preferably achieved electrically, for example by a spin transfer torque - STT mechanism.

In this case, the magnetic control element may be structured as a spin valve or a magnetic tunnel junction. It then comprises:
- a layer 87 made of a non-magnetic metal, for example Cu or MgO.
- a so-called reference magnetic layer 88, whose magnetisation is fixed.
- additional layers 89 for the proper functioning of the stack of layers, as it is well known for spin valves and magnetic tunnel junctions.
- a conductive electrode 80.

The application of a suitable voltage on the electrode 80 by a voltage source 81 (embedded in module 71 for example) allows the magnetisation to be set in one direction or the other, depending on the state in which the corresponding gate 53 is to be set.

Setting the magnetization in one direction or the other will favours or impedes the passage of the magnetic domain wall from one chamber to the next. With such a magnetic control element, the control of the underlying gate is binary.

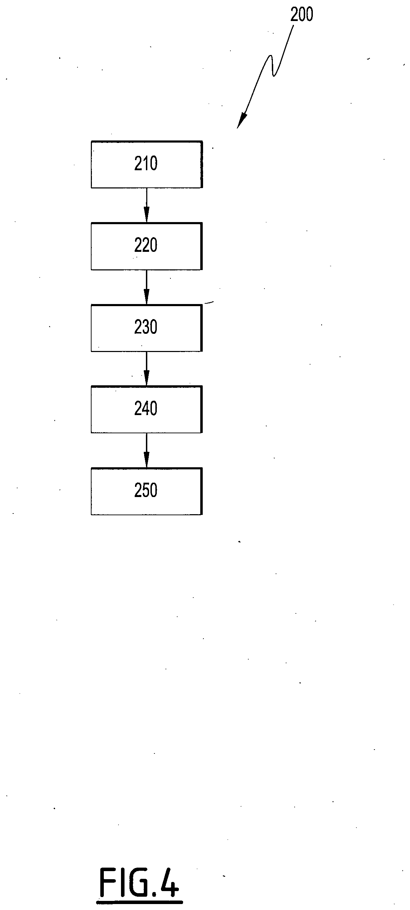

A method of use is shown in Figure 4.

According to the method 200, the classification device 20 is used in order to perform a classification task.

In step 210, the conformation means 23 is used to set the state of each gate. The plurality of gates remains in that state for the entire classification task.

In step 220, the medium 50 is first reinitialised using means 21 to place the medium in the initial magnetic configuration.

In step 230, a first signal of interest is encoded in the form of an excitation magnetic field, that is then applied by the excitation means 22 to the medium 50 so as to move the magnetic domain walls.

In step 240, the readout means 24 is used for the reading of the final magnetic configuration reached by the medium 50.

In step 250, the read-out signal is transmitted to the identification stage 30 for an identification of the class to which the signal of interest belongs.

After the classification of the first signal of interest, the conformation of the plurality of gates may bekept for an iteration of the same classification task (i.e. iteration of steps 230, 240 and 250) but on a second signal of interest different from the first signal of interest.

Alternatively, the conformation of the plurality of gates may be modified to perform another classification task. This allows the classification device to be adaptable in order to be used for different specific applications.

The conformation of the plurality of gates may also be modified to perform another classification task but still on the first signal of interest. Thus, the signal is processed again but with a different material system. This possibility allows for more complex treatments without increasing the physical size of the material system.

The conformation of the plurality of gates can be done according to the response of the overall material system 20, or a sub-part of the material system 20. This is particularly useful, for example, in the case where the state initially chosen for a gate is not adapted to the signal to be processed and the classification task to be performed. For example, let's consider a gate which is very difficult to pass through, i.e. the succession of pulses making up the signal does not allow the magnetic domain wall to reach the potential barrier threshold to cross that gate. In this case, the rest of the signal cannot be processed since it is blocked at that gate. The presence of such a strong trapping centre for the signal to be processed will be very unfavourable for the classification task. More generally, the analysis of the signal processing makes it possible to judge whether or not the configuration of the gates of the system is adapted to the signal to be processed and whether or not it needs to be modified. This is advantageously performed in an initial development phase of the classification device to identify the conformation of the gates that leads to an optimization of the classification task.

A database is separated into a first database that is used for training and a second database that is used for inference. Of this first database, a part is also used for analysis and determination of a suitable configuration (usually about 5% or less of the training database).

We start by using the files stored in this part of the first database. After having tested several files, we then check whether the gates are too blocked, or even completely blocked, or, on the contrary, whether they allow the domain wall to pass through too easily (typically following a low number of pulses or even following a single pulse). We then adjust the coupling of the targeted gates (preferably in a continuous or quasi-continuous way). We proceed to a new test. One iteration can be enough but more generally several iterations are necessary (typically if a gate is too blocking, it prevents the test of the following gates, which can also cause issues and have to be adjusted).

The rest of the training database is then used to train the identification stage 30.

A second embodiment will now be described.

One of the limitations of the first embodiment is related to the high energy consumption required for exciting the medium by means of a variable magnetic field.

In this second embodiment, the excitation means 22 generates an excitation quantity that is a constant magnetic field Bₑₓₜ. For example, means 22 may be a permanent magnet. At the same time, the input signal Sᵢₙ is applied to the conformation means 23.

The permanent magnet is placed in the vicinity of the medium so as to apply a constant magnetic field capable of moving the magnetic domain walls at any point of medium 50. This magnetic field typically has an amplitude between 1mT and 5mT. This magnetic field is nevertheless insufficient to nucleate new domains. With the use of a permanent magnet, the excitation of the medium is done without any energy consumption.

The signal to be processed is now used for controlling the state of the gates.

Since the input signal is analog, in this second embodiment the control element is preferably an electric control element. It creates a local electric field that modifies the potential barrier in the magnetic material at the gate to control the propagation of the magnetic domain wall. The electric field will locally modify the properties of the magnetic material, such as for example the anisotropy or the Dzyaloshinskii-Morya interaction - DMI constant. The advantage of using an electric field is the ability to control continuously the state of the gate with a simple voltage.

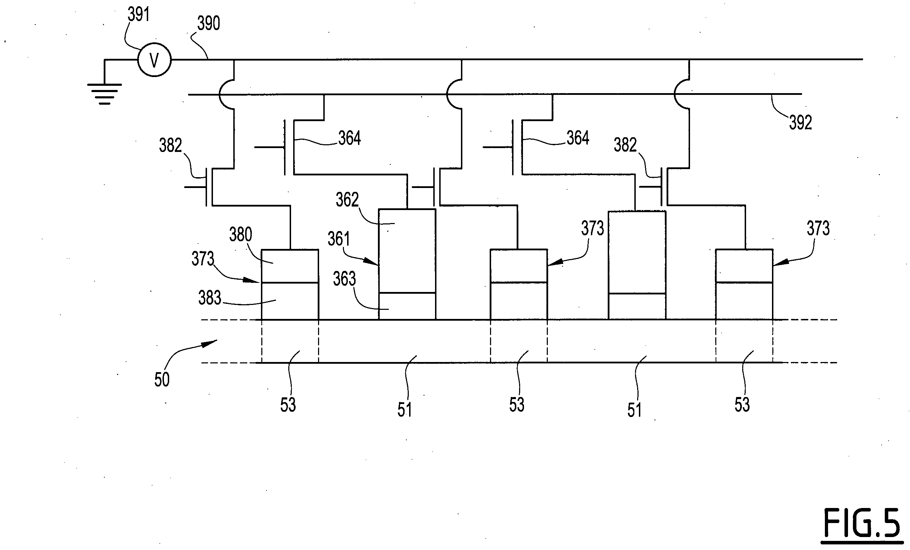

As shown for example in Figure 5, the electric control element 373 comprises an electrode 380 placed on the magnetic medium 50, above the gate 53 to be controlled. Preferably, a contact layer 383 is interposed between the electrode and the medium.

The typical material used for the electrode 380 is a conductive material such as Pt, Al, Ir, Ru, Cu, Au, Pd,... The contact layer 383 consists of a dielectric material such as AlOx, MgOx, ZnOx, SiOx... This material has to be an electrical insulator and other materials than oxides can be used.

One electrode 380 is connected to a control line 390 via an addressing control transistor 382, which is controlled via its grid.

The magnetic state of one chamber 51 is read by means of sensor 361. This latter operates for example as a magnetic tunnel junction made up of the medium 50 (which acts as the lower electrode of the tunnel junction), an insulating layer 363 (typically made of MgO), and a stack of layers 362 (defining, in particular, the magnetic reference layer and the upper electrode). This stack of layers 362 is connected, via an addressing readout transistor 364 to a readout line 392. The readout line 392 allows the reading of the resistance state of each sensor 361, as commonly done in MRAM technology.

The control line 390 is brought to a potential by a voltage generator 391 sufficient to induce the desired change in the state of the underlying gate 53. This voltage is typically between -10V and +10V, preferably between -5V and +5V and at best between -2V and +2V.

Thus, the magnetic domain wall, pushed by the permanent magnetic field Bₑₓₜ passes through one gate more or less easily according to the voltage applied.

The input signal Sᵢₙ from the pre-processing stage 10 is applied to the grids of the addressing control transistors 382. This input signal takes for example the form of a temporal succession of pulses of equal amplitude. It is applied to all the control addressing transistors 382 at the same time. Each of these transistors is thus turned on and off simultaneously by means of the pulse applied to its gate.

Alternatively, the addressing control transistors do not have to be used in an on/off switch mode. They can also be used in an analog mode.

This allows to continuously modulate the coupling between chambers.

Defining the state of the gates is done without any current, which further contributes to the reduction of the energy consumption of this second embodiment.

This second embodiment can have several alternatives:
- The input signal can be sent to only a part of the gates for a first time interval, less than the duration of the signal of interest to be processed, and then, to another part of the gates for a second time interval.
- The pre-processed signal is applied, as a voltage, to the control line 390 rather than to the grid of the addressing control transistors. The addressing control transistors 382 are open or simply replaced by mere connection lines.

This second embodiment, which only requires the manufacture of electrodes, can be easily fabricated with the usual micro and nanomanufacturing techniques.

In another alternatives the control element for controlling the state of one gate is a thermal control element, rather than a magnetic or electric control element.

In this case, a local change in temperature is created so as to locally alter the magnetic properties of the medium in a manner defining the possible states of the gate.

For example, a resistive element is placed on the medium directly above the gate to control. It is heated by Joule effect when a current is applied.

Alternatively, local heating is produced by radiation, for example a laser beam. In this case, an intermediate element can be added to optimise the heating, for example a layer with a high absorption of the laser beam at its particular wavelength.

Any other method known to locally modify the propagation of magnetic domain walls is encompassed: pinning, depinning, modification of the propagation velocity, ... For example, it has recently been reported that the depinning of magnetic domain walls can be facilitated by the presence of surface acoustic waves.

As indicated above, only one part of the gates is controllable. Alternatively, several gates are controlled by the same control element.

With the present invention, the material system can be modified to make it even more versatile. This makes it possible to analyse very different signals of interest, from various databases or with very different frequency signatures..

The coupling link between two zones is not always structured "in hard" in the medium, like gates, but defined by an electric electrode placed vertically above the medium at the interface between the two zones. The medium is then like a long corridor interspersed with electrodes. An electrode then applies an electric field to modulate the local properties of the medium.

## Claims

1. A classification device (1) comprising a pre-processing stage (10), an identification stage (30), and a material system (20) interposed between the pre-processing stage and the identification stage,
wherein:
- the material system (20) comprises an inhomogeneous magnetic medium (50), the inhomogeneous magnetic medium being a magnetic medium subdivided into a plurality of zones (51), each zone being either in a first magnetic state in which a magnetization (M1) of said zone is oriented in a first direction, or in a second magnetic state in which the magnetization (M2) of said zone is oriented in a second direction opposite to the first direction, each zone of the plurality of zones being in magnetic communication with at least one neighbouring zone of the plurality of zones through a coupling link, said coupling link being **characterized by** a magnetic coupling value, each zone of the plurality of zones being in magnetic communication with a source zone (52) of the plurality of zones, either directly or indirectly through one or more intermediate zones of the plurality of zones ;
- the material system (20) comprises an initialization means (21) for placing the plurality of zones (51) of the inhomogeneous magnetic medium (50) in a predefined initial magnetic configuration, wherein the plurality of zones is in the first magnetic state with the exception of the source zone (52), which is placed at least partially in the second magnetic state;
- the pre-processing stage (10) is adapted to transform a signal of interest (S₀) into a pre-processed signal (Sᵢₙ);
- the material system (20) comprises an excitation means (22) for generating a physical excitation quantity adapted to excite the inhomogeneous magnetic medium (50) so as to move magnetic domain walls (56), a magnetic domain wall being located at each interface between a first zone of the plurality of zones of the inhomogeneous magnetic medium (50) placed in the first magnetic state and a second zone of the inhomogeneous magnetic medium (50) placed in the second magnetic state, the excitation means (22) being configured to apply the physical excitation quantity during a predefined time interval so as to increase the number of second zones in the second magnetic state from the source zone (52);
- the material system (20) comprises a readout means (24) for measuring, after application of the physical excitation quantity, the magnetic state of the plurality of zones so as to define a final magnetic configuration reached by the inhomogeneous magnetic medium (50), the final magnetic configuration being applied as an input to the identification stage (30);
- the identification stage (30) is adapted to determine a class (Cᵢ) to which the signal of interest (S₀) belongs among a plurality of predetermined classes from the final magnetic configuration; wherein the classification device is **characterized in that**:
- the material system (20) comprises a conformation means (23) for dynamically setting the respective magnetic coupling value of one or several coupling links.

2. The classification device (1) according to claim 1, wherein the excitation means (22) is configured to generate the physical excitation quantity from the pre-processed signal (Sᵢₙ).

3. The classification device (1) according to claim 1, wherein the conformation means (23) is configured to adjust the magnetic coupling value of at least one coupling link from the pre-processed signal (Sᵢₙ).

4. The classification device (1) according to claim 3, wherein the excitation means (22) comprises a permanent magnet.

5. The classification device (1) according to any one of claims 1 to 4, wherein each of the one or several coupling links corresponds to a gate (53) delimited in the inhomogeneous magnetic medium (50), the magnetic coupling value of said coupling link defining a current state of its gate (53), and wherein the conformation means (23) comprises at least one control element (73), each control element (73) being configured to define the current state of the gate (53) of one or more of the coupling links.

6. The classification device (1) according to any one of claims 1 to 5, wherein the conformation means is a magnetic control means.

7. The classification device (1) according to any one of claims 1 to 5, wherein the conformation means is an electric control means.

8. The classification device (1) according to any one of claims 1 to 7, wherein the magnetic coupling value of each of the one or more coupling links is selected among a plurality of discrete values, the plurality of discrete values defining as many states for the corresponding coupling link.

9. The classification device (1) according to any one of claims 1 to 7, wherein the magnetic coupling value of each of the one or more coupling links is selected in an interval of values, the interval of values defining a continuum of states for the corresponding coupling link.

## Patentansprüche

1. Klassifizierungsvorrichtung (1), umfassend eine Vorverarbeitungsstufe (10), eine Identifizierungsstufe (30) und ein Materialsystem (20), das zwischen der Vorverarbeitungsstufe und der Identifizierungsstufe eingefügt ist,
wobei:
- das Materialsystem (20) ein inhomogenes magnetisches Medium (50) umfasst, wobei das inhomogene magnetische Medium ein magnetisches Medium ist, das in eine Vielzahl von Zonen (51) unterteilt ist, wobei jede Zone entweder in einem ersten magnetischen Zustand, in dem eine Magnetisierung (M1) der Zone in einer ersten Richtung ausgerichtet ist, oder in einem zweiten magnetischen Zustand ist, in dem die Magnetisierung (M2) der Zone in einer zweiten, der ersten Richtung entgegengesetzten Richtung ausgerichtet ist, wobei jede Zone der Vielzahl von Zonen mit mindestens einer benachbarten Zone der Vielzahl von Zonen durch eine Kopplungsanbindung in magnetischer Verbindung steht, wobei die Kopplungsanbindung **gekennzeichnet ist durch** einen magnetischen Kopplungswert, wobei jede Zone der Vielzahl von Zonen in magnetischer Verbindung mit einer Quellzone (52) der Vielzahl von Zonen steht, entweder direkt oder indirekt **durch** eine oder mehrere Zwischenzonen der Vielzahl von Zonen;
- das Materialsystem (20) ein Initialisierungsmittel (21) zum Versetzen der Vielzahl von Zonen (51) des inhomogenen magnetischen Mediums (50) in eine vordefinierte anfängliche magnetische Konfiguration umfasst, wobei die Vielzahl von Zonen in dem ersten magnetischen Zustand ist, mit Ausnahme der Quellzone (52), die mindestens teilweise in den zweiten magnetischen Zustand versetzt ist;
- die Vorverarbeitungsstufe (10) angepasst ist, um ein Signal von Interesse (S₀) in ein vorverarbeitetes Signal (Sᵢₙ) umzuwandeln;
- das Materialsystem (20) ein Anregungsmittel (22) zum Erzeugen einer physikalischen Anregungsgröße umfasst, die angepasst ist, um das inhomogene magnetische Medium (50) anzuregen, um magnetische Domänenwände (56) zu bewegen, wobei sich eine magnetische Domänenwand an jeder Grenzfläche zwischen einer ersten Zone der Vielzahl von Zonen des inhomogenen magnetischen Mediums (50), die in den ersten magnetischen Zustand versetzt ist, und einer zweiten Zone des inhomogenen magnetischen Mediums (50), die in den zweiten magnetischen Zustand versetzt ist, befindet, wobei das Anregungsmittel (22) konfiguriert ist, um die physikalische Anregungsgröße während eines vordefinierten Zeitintervalls anzulegen, um die Anzahl von zweiten Zonen in dem zweiten magnetischen Zustand aus der Quellzone (52) zu erhöhen;
- das Materialsystem (20) ein Auslesemittel (24) zum Messen, nach Anlegen der physikalischen Anregungsgröße, des magnetischen Zustands der Vielzahl von Zonen, um eine endgültige magnetische Konfiguration zu definieren, die **durch** das inhomogene magnetische Medium (50) erreicht wird, wobei die endgültige magnetische Konfiguration als eine Eingabe an die Identifikationsstufe (30) angelegt wird;
- die Identifikationsstufe (30) angepasst ist, um eine Klasse (Cᵢ), zu der das Signal von Interesse (S₀) gehört, unter einer Vielzahl von vorbestimmten Klassen aus der endgültigen magnetischen Konfiguration zu bestimmen; wobei die Klassifizierungsvorrichtung **dadurch** gekennzeichnet ist, dass:
- das Materialsystem (20) ein Konformationsmittel (23) zum dynamischen Einstellen des jeweiligen magnetischen Kopplungswerts einer oder mehrerer Kopplungsanbindungen umfasst.

2. Klassifizierungsvorrichtung (1) nach Anspruch 1, wobei das Anregungsmittel (22) konfiguriert ist, um die physikalische Anregungsgröße aus dem vorverarbeiteten Signal (Sᵢₙ) zu erzeugen.

3. Klassifizierungsvorrichtung (1) nach Anspruch 1, wobei das Konformationsmittel (23) konfiguriert ist, um den magnetischen Kopplungswert mindestens einer Kopplungsanbindung aus dem vorverarbeiteten Signal (Sᵢₙ) zu justieren.

4. Klassifizierungsvorrichtung (1) nach Anspruch 3, wobei das Anregungsmittel (22) einen Dauermagneten umfasst.

5. Klassifizierungsvorrichtung (1) nach einem der Ansprüche 1 bis 4, wobei jede der einen oder mehreren Kopplungsanbindungen einem Gatter (53) entspricht, das in dem inhomogenen magnetischen Medium (50) begrenzt ist, wobei der magnetische Kopplungswert der Kopplungsanbindung einen aktuellen Zustand seines Gatters (53) definiert, und wobei das Konformationsmittel (23) mindestens ein Steuerelement (73) umfasst, wobei jedes Steuerelement (73) konfiguriert ist, um den aktuellen Zustand des Gatters (53) einer oder mehrerer der Kopplungsanbindungen zu definieren.

6. Klassifizierungsvorrichtung (1) nach einem der Ansprüche 1 bis 5, wobei das Konformationsmittel ein magnetisches Steuermittel ist.

7. Klassifizierungsvorrichtung (1) nach einem der Ansprüche 1 bis 5, wobei das Konformationsmittel ein elektrisches Steuermittel ist.

8. Klassifizierungsvorrichtung (1) nach einem der Ansprüche 1 bis 7, wobei der magnetische Kopplungswert jeder der einen oder mehreren Kopplungsanbindungen aus einer Vielzahl von diskreten Werten ausgewählt ist, wobei die Vielzahl von diskreten Werten ebenso viele Zustände für die entsprechende Kopplungsanbindung definiert.

9. Klassifizierungsvorrichtung (1) nach einem der Ansprüche 1 bis 7, wobei der magnetische Kopplungswert jeder der einen oder mehreren Kopplungsanbindungen in einem Intervall von Werten ausgewählt ist, wobei das Intervall von Werten ein Kontinuum von Zuständen für die entsprechende Kopplungsanbindung definiert.

## Revendications

1. Dispositif de classification (1) comprenant un étage de prétraitement (10), un étage d'identification (30), et un système matériel (20) interposé entre l'étage de prétraitement et l'étage d'identification,
dans lequel :
- le système matériel (20) comprend un milieu magnétique inhomogène (50), le milieu magnétique inhomogène étant un milieu magnétique subdivisé en une pluralité de zones (51), chaque zone étant soit dans un premier état magnétique dans lequel une aimantation (M1) de ladite zone est orientée dans une première direction, soit dans un second état magnétique dans lequel l'aimantation (M2) de ladite zone est orientée dans une seconde direction opposée à la première direction, chaque zone de la pluralité de zones étant en communication magnétique avec au moins une zone voisine de la pluralité de zones par l'intermédiaire d'une liaison de couplage, ladite liaison de couplage étant **caractérisée par** une valeur de couplage magnétique, chaque zone de la pluralité de zones étant en communication magnétique avec une zone source (52) de la pluralité de zones, directement ou indirectement par l'intermédiaire d'une ou plusieurs zones intermédiaires de la pluralité de zones ;
- le système matériel (20) comprend un moyen d'initialisation (21) pour placer la pluralité de zones (51) du milieu magnétique inhomogène (50) dans une configuration magnétique initiale prédéfinie, dans lequel la pluralité de zones est dans le premier état magnétique à l'exception de la zone source (52), qui est placée au moins partiellement dans le second état magnétique ;
- l'étage de prétraitement (10) est adapté pour transformer un signal d'intérêt (S₀) en un signal prétraité (Sᵢₙ) ;
- le système matériel (20) comprend un moyen d'excitation (22) pour générer une grandeur physique d'excitation adaptée pour exciter le milieu magnétique inhomogène (50) de manière à déplacer des parois de domaines magnétiques (56), une paroi de domaine magnétique étant située au niveau de chaque interface entre une première zone de la pluralité de zones du milieu magnétique inhomogène (50) placée dans le premier état magnétique et une seconde zone du milieu magnétique inhomogène (50) placée dans le second état magnétique, le moyen d'excitation (22) étant configuré pour appliquer la grandeur physique d'excitation pendant un intervalle de temps prédéfini de manière à augmenter le nombre de secondes zones dans le second état magnétique à partir de la zone source (52) ;
- le système matériel (20) comprend un moyen de lecture (24) pour mesurer, après application de la grandeur physique d'excitation, l'état magnétique de la pluralité de zones de manière à définir une configuration magnétique finale atteinte par le milieu magnétique inhomogène (50), la configuration magnétique finale étant appliquée en tant qu'entrée à l'étage d'identification (30) ;
- l'étage d'identification (30) est adapté pour déterminer une classe (Cᵢ) à laquelle le signal d'intérêt (S₀) appartient parmi une pluralité de classes prédéterminées à partir de la configuration magnétique finale ; dans lequel le dispositif de classification est **caractérisé en ce que** :
- le système matériel (20) comprend un moyen de conformation (23) pour régler dynamiquement la valeur de couplage magnétique respective d'une ou de plusieurs liaisons de couplage.

2. Dispositif de classification (1) selon la revendication 1, dans lequel le moyen d'excitation (22) est configuré pour générer la grandeur physique d'excitation à partir du signal prétraité (Sᵢₙ).

3. Dispositif de classification (1) selon la revendication 1, dans lequel le moyen de conformation (23) est configuré pour ajuster la valeur de couplage magnétique d'au moins une liaison de couplage à partir du signal prétraité (Sᵢₙ).

4. Dispositif de classification (1) selon la revendication 3, dans lequel le moyen d'excitation (22) comprend un aimant permanent.

5. Dispositif de classification (1) selon l'une quelconque des revendications 1 à 4, dans lequel chacune de la ou des liaisons de couplage correspond à une porte (53) délimitée dans le milieu magnétique inhomogène (50), la valeur de couplage magnétique de ladite liaison de couplage définissant un état courant de sa porte (53), et dans lequel le moyen de conformation (23) comprend au moins un élément de commande (73), chaque élément de commande (73) étant configuré pour définir l'état courant de la porte (53) d'une ou plusieurs des liaisons de couplage.

6. Dispositif de classification (1) selon l'une quelconque des revendications 1 à 5, dans lequel le moyen de conformation est un moyen de commande magnétique.

7. Dispositif de classification (1) selon l'une quelconque des revendications 1 à 5, dans lequel le moyen de conformation est un moyen de commande électrique.

8. Dispositif de classification (1) selon l'une quelconque des revendications 1 à 7, dans lequel la valeur de couplage magnétique de chacune de la ou des liaisons de couplage est sélectionnée parmi une pluralité de valeurs discrètes, la pluralité de valeurs discrètes définissant autant d'états pour la liaison de couplage correspondante.

9. Dispositif de classification (1) selon l'une quelconque des revendications 1 à 7, dans lequel la valeur de couplage magnétique de chacune de la ou des liaisons de couplage est sélectionnée dans un intervalle de valeurs, l'intervalle de valeurs définissant un continuum d'états pour la liaison de couplage correspondante.
